# EUROPEAN PATENT APPLICATION

(11) **EP 4 730 924 A1**
(43) Date of publication of application: **22.04.2026**
(21) Application number: 24826180.2
(22) Date of filing: 11.06.2024
(51) Int. Cl.: H05K 1/14, H01R 12/71, H01R 12/72, H05K 3/36, G06F 1/16

(54) **CIRCUIT BOARD ASSEMBLY AND ELECTRONIC DEVICE INCLUDING SAME**

(30) Priority: 19.06.2023 KR 20230078498; 14.07.2023 KR 20230091929
(71) Applicant: Samsung Electronics Co., Ltd., Suwon-si, Gyeonggi-do 16677 (KR)
(72) Inventor: JUNG, Kisung, Suwon-si Gyeonggi-do 16677 (KR); CHOI, Myoungjun, Suwon-si Gyeonggi-do 16677 (KR)
(74) Representative: Gulde & Partner
(86) International application number: PCT/KR2024/007957
(87) International publication number: WO 2024/262859

(57) **Abstract**

According to an embodiment of the present disclosure, an electronic device may include: a housing; a first circuit board disposed in the housing, the first circuit board including a first recess, a second recess spaced apart from the first recess, a first connector area of which opposite edges are defined by the first recess and the second recess, and a third recess recessed from at least a portion of the first recess; a conductive contact member including a second connector area electrically connected to the first connector area; and a bracket surrounding at least a portion of the first connector area and at least a portion of the second connector area, the bracket including a first side wall to be inserted into the first recess, a second side wall to be inserted into the second recess, and a first insertion portion formed on the first side wall, wherein the first insertion portion may be inserted into the third recess.

## Description

### [Technical Field]

Various embodiments disclosed herein relate to an electronic device, for example, a circuit board assembly and an electronic device including the same.

### [Background Art]

Due to the remarkable development of information communication technology and semiconductor technology, the distribution and use of various electronic devices are rapidly increasing. In particular, recent electronic devices are being developed to be portable and capable of communication.

The term "electronic device" may refer to a device that performs a specific function based on an installed program, such as a home appliance, an electronic scheduler, a portable multimedia player, a mobile communication terminal, a tablet PC, a video/audio device, a desktop/laptop PC, or a vehicle navigation system. The above-mentioned electronic devices may output, for example, information stored therein as audio or video. As the degree of integration of electronic devices increases and ultra-high-speed and high-capacity wireless communication become more widespread, a single electronic device, such as a mobile communication terminal, may be now equipped with various functions. For example, not only communication functions but also entertainment functions such as gaming, multimedia functions such as music and video playback, communication and security functions for mobile banking, or various function such as schedule management or electronic wallet are being integrated into a single electronic device. Such an electronic device is being miniaturized to allow a user to conveniently carry it.

The above-described information may be provided as related art for the purpose of helping to understand the disclosure. No claim or determination is made as to whether any of the foregoing may be applied as prior art with respect to the disclosure.

### [Detailed Description of the Invention]

### [Technical Solution]

According to an embodiment of the disclosure, an electronic device may include a housing and a first circuit board disposed in the housing. The first circuit board may include a first recess recessed from an edge of the first circuit board, a second recess recessed from an edge of the first circuit board and spaced apart from the first recess, a first connector area, in which both edges of the first connector area are defined by the first recess and the second recess, and a third recess recessed in at least a portion of the first recess. The electronic device may further include a conductive connection member including a second connector area electrically connected to the first connector area, and a bracket surrounding at least a portion of the first connector area and at least a portion of the second connector area, in which the bracket includes a first side wall inserted into the first recess, a second side wall inserted into the second recess, and a first inserting portion formed in the first side wall. The first inserting portion may be inserted into the third recess.

According to an embodiment of the disclosure, a circuit board assembly may include a first recess recessed from an edge of the first circuit board, a second recess recessed from an edge of the first circuit board and spaced apart from the first recess, a first connector area, in which both edges of the first connector area are defined by the first recess and the second recess, and a third recess recessed in at least a portion of the first recess. The circuit board assembly may further include a conductive connection member including a second connector area electrically connected to the first connector area, and a bracket surrounding at least a portion of the first connector area and at least a portion of the second connector area, in which the bracket includes a first side wall inserted into the first recess, a second side wall inserted into the second recess, and a first inserting portion formed in the first side wall. The first inserting portion may be inserted into the third recess.

### [Brief Description of Drawings]

FIG. 1 is a block diagram of an electronic device according to various embodiments in a network environment.
FIG. 2 is a perspective view of an electronic device according to an embodiment of the disclosure in a folded state.
FIG. 3 is a perspective view of an electronic device according to an embodiment of the disclosure in an unfolded state.
FIG. 4 is a plan view illustrating an interior of a housing of an electronic device according to an embodiment of the disclosure.
FIG. 5 is a perspective view illustrating a pre-assembly state of a bracket of a circuit board assembly according to an embodiment of the disclosure.
FIG. 6 is a perspective view illustrating a post-assembly state of the bracket of the circuit board assembly according to an embodiment of the disclosure.
FIG. 7 is a plan view illustrating a connector of a first circuit board according to an embodiment of the disclosure.
FIG. 8 is a plan view illustrating a ground of the first circuit board according to an embodiment of the disclosure.
FIG. 9 is a perspective view illustrating a bracket according to an embodiment of the disclosure.
FIG. 10 is a side view illustrating a post-assembly state of a circuit board assembly according to an embodiment of the disclosure.
FIG. 11 is a perspective view illustrating a pre-assembly state of a bracket of a circuit board assembly according to an embodiment of the disclosure.
FIG. 12 is a perspective view illustrating a post-assembly state of the bracket of the circuit board assembly according to an embodiment of the disclosure.
FIG. 13 is a plan view illustrating a connector of a first circuit board according to an embodiment of the disclosure.
FIG. 14 is a plan view illustrating a ground of the first circuit board according to an embodiment of the disclosure.
FIG. 15 is a perspective view illustrating a bracket according to an embodiment of the disclosure.
FIG. 16 is a side view illustrating a post-assembly state of a circuit board assembly according to an embodiment of the disclosure.

### [Mode for Carrying out the Invention]

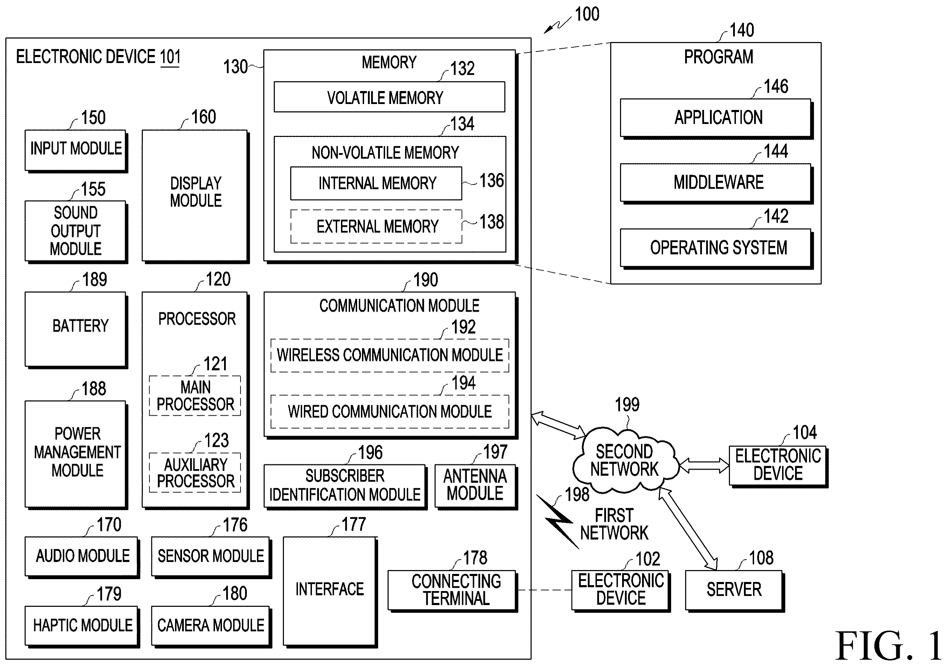

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

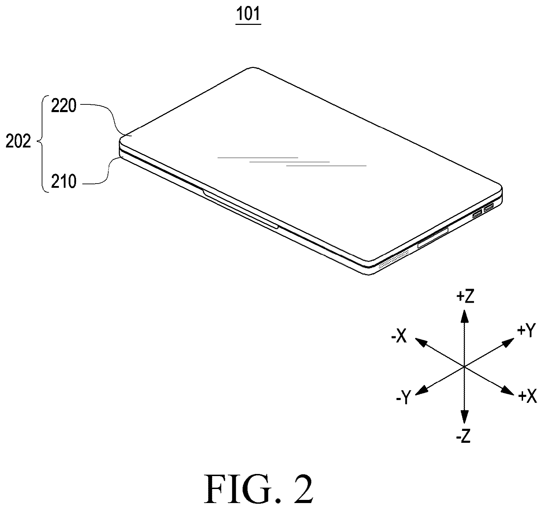

FIG. 2 is a perspective view of an electronic device according to an embodiment of the disclosure in a folded state.

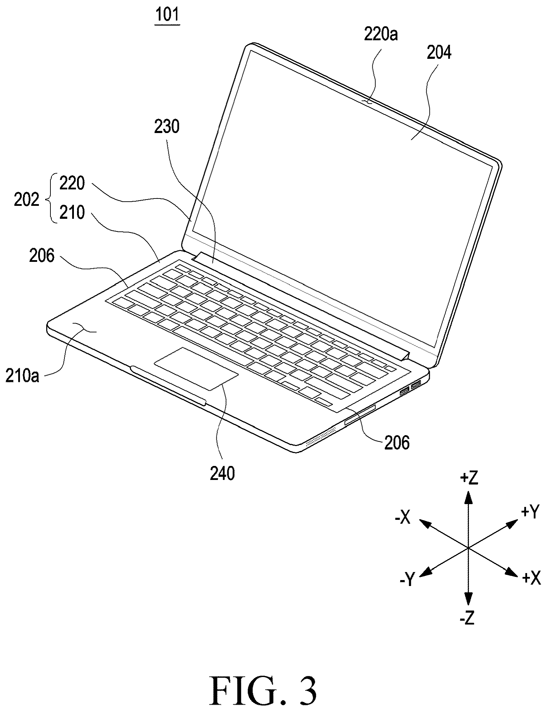

FIG. 3 is a perspective view of an electronic device according to an embodiment of the disclosure in an unfolded state.

The embodiments of FIGS. 2 and 3 may be combined with the embodiment of FIG. 1 or the embodiments of FIGS. 3 to 16.

Referring to FIGS. 2 to 3, the electronic device 101 may include a housing 202, a display 204, and a touch pad module 240. According to an embodiment, the electronic device 101 may be a laptop computer, a notebook computer, or a portable terminal. The configuration of the electronic device 101 in FIGS. 2 to 3 may be partially or entirely the same as the configuration of the electronic device 101 in FIG. 1.

According to an embodiment, the housing 202 may form at least a portion of an exterior of the electronic device 101 or may support a component of the electronic device 101 (e.g., the touch pad module 240). For example, the housing 202 may accommodate at least one of the display 204, an input device 206, or the touch pad module 240.

According to an embodiment, the electronic device 101 may be opened (e.g., FIG. 3) or closed (e.g., FIG. 2). For example, the housing 202 may include a first housing 210 and a second housing 220 rotatably connected to the first housing 210. According to an embodiment, the electronic device 101 may include a hinge module 230 connected to the housing 202. For example, the hinge module 230 may be connected to the first housing 210 and the second housing 220. According to an embodiment, the first housing 210 may be configured to rotate relative to the second housing 220 at a predetermined angle (e.g., 0 degrees to 180 degrees, or 0 degrees to 360 degrees). According to an embodiment, the second housing 220 may be defined and/or interpreted as rotating relative to the first housing 210 over a predetermined angle. For example, in a closed state of the electronic device 101 (e.g., FIG. 2), a first front surface 210a of the first housing 210 may face a second front surface 220a of the second housing 220.

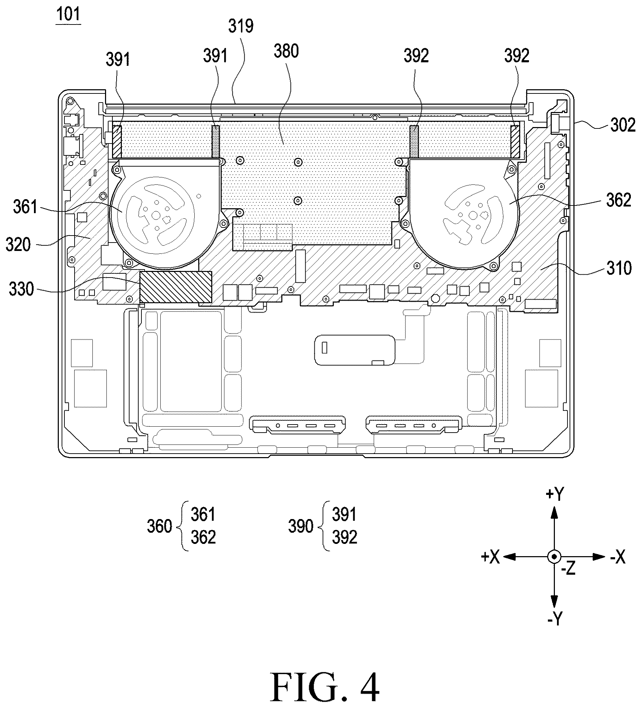

According to an embodiment, the housing 202 may be formed of a metallic material or a non-metallic material having rigidity of a selected magnitude. According to an embodiment, at least a portion of the electronic device 101 formed of the metallic material may provide a ground plane and may be electrically connected to a ground line formed on a printed circuit board (e.g., the first circuit board 310 of FIG. 4). For example, the housing 202 may be electrically connected to the printed circuit board via a capacitive component.

According to an embodiment, at least a portion of the display 204 may be disposed in the second housing 220. For example, at least a portion of the display 204 may be visually exposed to the outside of the electronic device 101 through the second housing 220. The display 204 may form at least a portion of the second front surface 220a of the second housing 220. According to an embodiment, the display 204 may be a flexible display configured to be deformed in a portion into a flat surface and/or a curved surface. For example, the display 204 may be a foldable or rollable display. The configuration of the display 204 may be partially or entirely the same as the configuration of the display module 160 of FIG. 1.

According to an embodiment, the display 204 may be coupled with or disposed adjacent to a digitizer configured to detect a touch sensing circuit, a pressure sensor configured to measure an intensity of a touch (pressure), and/or a magnetic-field-based stylus pen.

According to an embodiment, the input device 206 may detect a user input (e.g., pressure). According to an embodiment, the input device 206 may be disposed on or accommodated in the first housing 210. According to an embodiment, in the closed state of the electronic device 101, the input device 206 may face the display 204. The configuration of the input device 206 in FIG. 2 may be partially or entirely the same as the configuration of the input module 150 of FIG. 1. For example, the input device 206 may be a keyboard.

According to an embodiment, the touch pad module 240 may be configured to detect or receive a user input. According to an embodiment, the touch pad module 240 may include a capacitive touch sensor, a resistive-detection-based touch sensor, an optical touch sensor, or a surface acoustic wave touch sensor. For example, the touch pad module 240 may detect current, pressure, light, and/or vibration resulting from a user input applied to the touch pad module 240, and the processor (e.g., the processor 120 of FIG. 1) and/or the touch pad module 240 may determine a user input based on changes in the detected current, pressure, light, and/or vibration. According to an embodiment, the touch pad module 240 may be referred to as a touch pad, a touch pad device, or a touch pad structure.

According to an embodiment, the processor (e.g., the processor 120 of FIG. 1) and/or the touch pad module 240 may determine a position of a user input (e.g., an XY coordinate). According to an embodiment, the touch pad module 240 may detect pressure applied to the touch pad module 240. For example, the touch pad module 240 may detect a force in a thickness direction (e.g., a Z-axis direction) by using a switch and at least one force sensor. According to an embodiment, when an external object (e.g., a user's finger or a stylus) directly touches or approaches a surface of the touch pad module 240, the touch pad module 240 may detect the external object.

According to an embodiment, the touch pad module 240 may be accommodated in the housing 202. For example, the touch pad module 240 may be connected to the first housing 210 and at least a portion thereof may be exposed to the outside of the first housing 210. According to an embodiment, the touch pad module 240 may be located adjacent to the input device 206. According to an embodiment, in the closed state of the electronic device 101, at least a portion of the touch pad module 240 may face the display 204. The configuration of the touch pad module 240 may be partially or entirely the same as the configuration of the input module 150 of FIG. 1.

FIG. 4 is a plan view illustrating an interior of a housing of an electronic device according to an embodiment of the disclosure.

The embodiment of FIG. 4 may be combined with the embodiments of FIGS. 1 to 3 or the embodiments of FIGS. 4 to 16.

Referring to FIG. 4, the electronic device 101 (e.g., the electronic device 101 of FIGS. 1 to 3) may include a housing 302, a first circuit board 310, a second circuit board 320, a conductive connection member 330, at least one fan module 360, a heat dissipation member 380, and at least one buffer member 390.

According to an embodiment, the electronic device 101 may include the housing 302 (e.g., the housing 302 of FIGS. 2 to 3). In the illustrated embodiment, the housing 302 may correspond to the first housing 210 of FIGS. 2 to 3. However, the housing 302 is not limited thereto and may correspond to the second housing 220 of FIGS. 2 and 3.

According to an embodiment, at least a portion of an edge of the housing 302 (e.g., at least a portion of an edge facing the +Y direction in FIG. 4) may include a stepped portion 319 that is recessed toward the inside of the housing 302 compared to other portions. A hinge module of the electronic device 101 (e.g., the hinge module 230 of FIG. 2) may be disposed in the stepped portion 319.

According to an embodiment, the hinge module (e.g., the hinge module 230 of FIG. 2) may be rotatably coupled to the housing 302 (e.g., the first housing 210 of FIG. 2).

According to an embodiment, an input device of the electronic device 101 (e.g., the input device 206 of FIG. 2) or the touch pad module (e.g., the touch pad module 240 of FIG. 2) may be disposed in the housing 302.

According to an embodiment, the housing 302 may include an internal space. The internal space of the housing 302 may be a space separated from an external space of the electronic device 101. The internal space may accommodate the first circuit board 310, the second circuit board 320, the conductive connection member 330, at least one fan module 360, the heat dissipation member 380, the at least one buffer member 390, or at least one electronic component (e.g., the processor 120, the memory 130, or the communication module 190 of FIG. 1).

According to an embodiment, the first circuit board 310 may be disposed inside the housing 302 (e.g., the first housing 210 of FIG. 2). According to an embodiment, the first circuit board 310 may include at least one of a printed circuit board (PCB), a flexible printed circuit board (flexible PCB), and a rigid-flexible printed circuit board (RF-PCB).

According to an embodiment, the second circuit board 320 may be disposed inside the housing 302 (e.g., the first housing 210 of FIG. 2). The second circuit board 320 may include at least one of a printed circuit board (PCB), a flexible printed circuit board (flexible PCB), and a rigid-flexible printed circuit board (RF-PCB).

According to an embodiment, the first circuit board 310 may be defined and/or referred to as a main circuit board, and the second circuit board 320 may be defined and/or referred to as a sub circuit board.

According to an embodiment, the first circuit board 310 and the second circuit board 320 may be spaced apart from each other.

According to an embodiment, at least one electronic component (e.g., the processor 120, the memory 130, or the communication module 190 of FIG. 1) may be disposed or mounted on the first circuit board 310.

According to an embodiment, the second circuit board 320 may be electrically connected to a speaker, a SIM socket, and/or the first circuit board 310.

According to an embodiment, the conductive connection member 330 may be disposed inside the housing 302. The conductive connection member 330 may be electrically connected to the first circuit board 310 and the second circuit board 320. For example, the conductive connection member 330 may be configured to transmit a signal from the first circuit board 310 to the second circuit board 320. In addition, the conductive connection member 330 may be configured to transmit a signal from the second circuit board 320 to the first circuit board 310. According to an embodiment, the conductive connection member 330 may include at least one of a flexible printed circuit board (FPCB), a printed circuit board (PCB), and a cable.

According to an embodiment, the heat dissipation member 380 may be disposed inside the housing 302 (e.g., the first housing 210 of FIG. 2). According to an embodiment, the heat dissipation member 380 may be disposed on at least a portion of the first circuit board 310. For example, the heat dissipation member 380 may be disposed on one surface of the first circuit board 310 (e.g., a surface facing the -Z direction of FIGS. 2 to 4).

According to an embodiment, the heat dissipation member 380 may include a vapor chamber, a heat pipe, a heat spreader, or a heat sink.

According to an embodiment, the heat dissipation member 380 may form a heat transfer path for releasing heat generated from the first circuit board 310, heat generated from at least one electronic component disposed on the first circuit board 310, or heat generated from an electronic component disposed inside the housing 302 (e.g., the first housing 210 of FIG. 2) to the outside of the housing 302.

According to an embodiment, at least a portion of the heat dissipation member 380 may be disposed between the at least one fan module 360 and the stepped portion 319 of the housing 302.

According to an embodiment, the at least one fan module 360 may be disposed inside the housing 302 (e.g., the first housing 210 of FIG. 2). According to an embodiment, the at least one fan module 360 may include a fan configured to generate air flow.

According to an embodiment, the at least one fan module 360 may provide air blowing to at least a portion of the heat dissipation member 380. For example, air blowing provided from the at least one fan module 360 may be discharged to the outside of the housing 302 after passing through at least a portion of the heat dissipation member 380. The air blowing provided from the at least one fan module 360 may be discharged to the outside of the housing 302 after performing heat exchange with the heat dissipation member 380. For example, heat accumulated inside the housing 302 may be released to the outside of the housing 302 through the heat dissipation member 380 and the air blowing.

According to an embodiment, the at least one fan module 360 may include a first fan module 361 and a second fan module 362 spaced apart from the first fan module 361.

According to an embodiment, the first fan module 361 may face at least a portion of the heat dissipation member 380, and the second fan module 362 may face a portion of the heat dissipation member 380 different from the at least a portion faced by the first fan module 361.

According to an embodiment, the electronic device 101 may further include the at least one buffer member 390. The at least one buffer member 390 may be disposed on one surface of the heat dissipation member 380 (e.g., a surface facing the -Z direction of FIGS. 2 to 4).

According to an embodiment, the at least one buffer member 390 may include at least one of a sponge or a rubber.

According to an embodiment, the at least one buffer member 390 may limit or reduce external impact applied to the electronic device 101 from being directly transmitted to the heat dissipation member 380.

According to an embodiment, the at least one buffer member 390 may include a first buffer member 391 and a second buffer member 392. The first buffer member 391 may be disposed adjacent to the first fan module 361, and the second buffer member 392 may be disposed adjacent to the second fan module 362.

According to an embodiment, the first buffer member 391 may be disposed on at least a portion of the heat dissipation member 380 that is disposed between the first fan module 361 and the stepped portion 319. The second buffer member 392 may be disposed on another portion of the heat dissipation member 380 that is disposed between the second fan module 362 and the stepped portion 319.

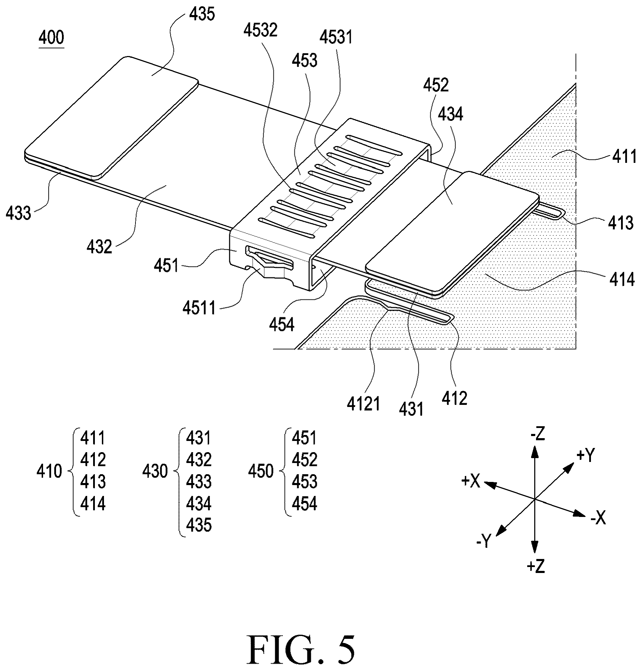

FIG. 5 is a perspective view illustrating a pre-assembly state of a bracket of a circuit board assembly according to an embodiment of the disclosure.

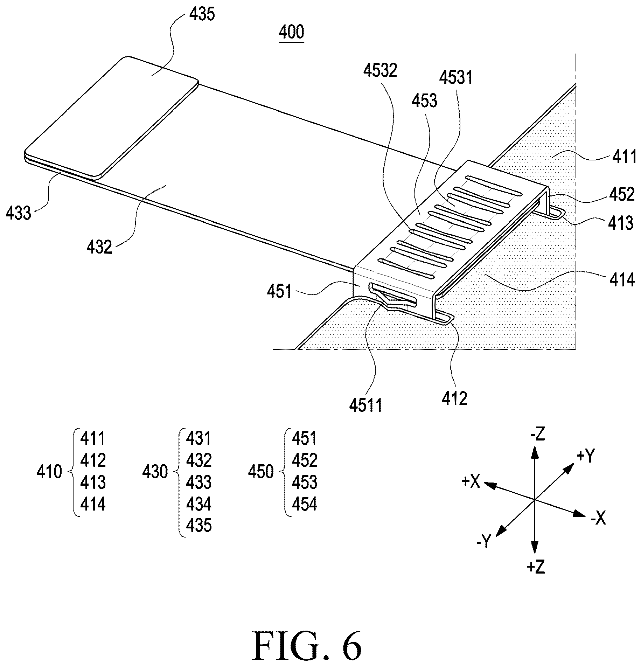

FIG. 6 is a perspective view illustrating a post-assembly state of the bracket of the circuit board assembly according to an embodiment of the disclosure.

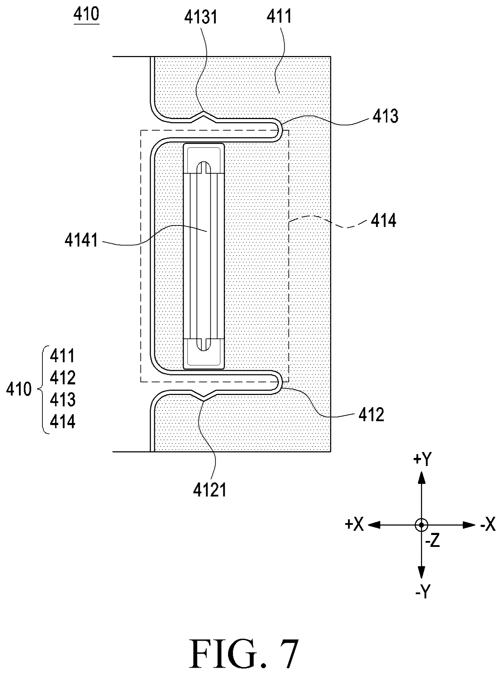

FIG. 7 is a plan view illustrating a connector of a first circuit board according to an embodiment of the disclosure.

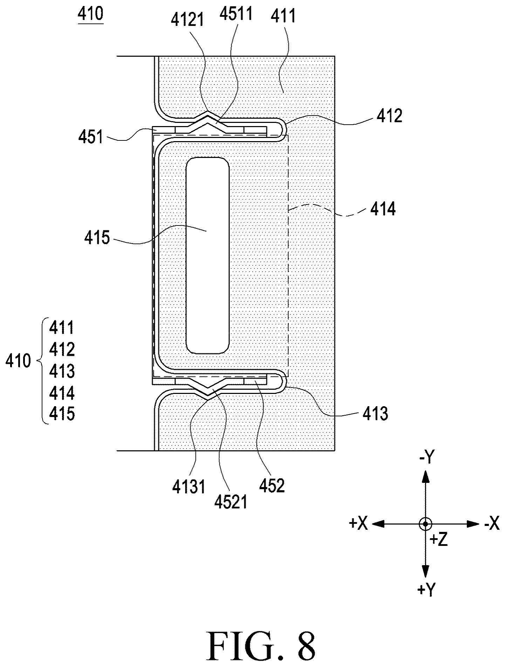

FIG. 8 is a plan view illustrating a ground of the first circuit board according to an embodiment of the disclosure.

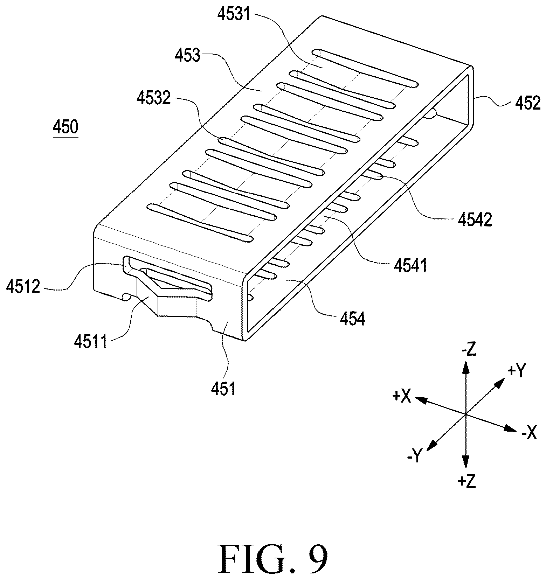

FIG. 9 is a perspective view illustrating a bracket according to an embodiment of the disclosure.

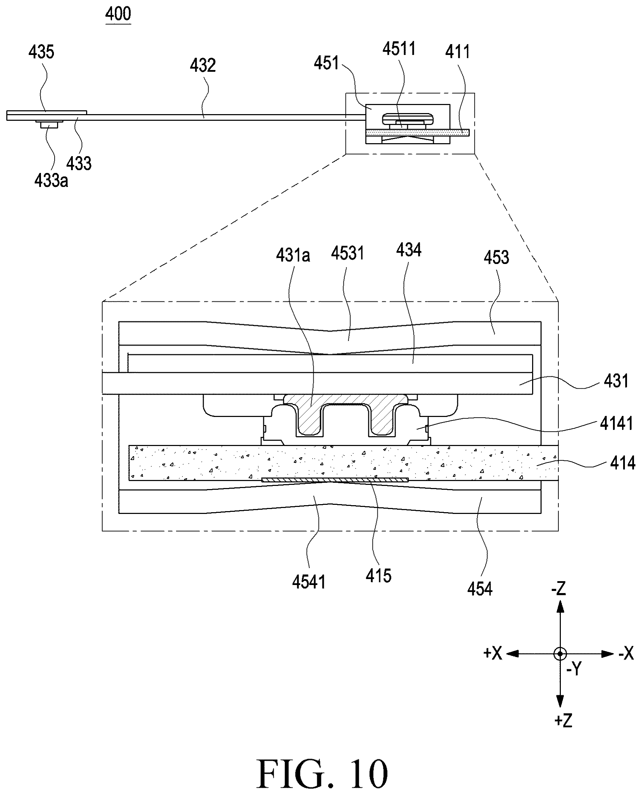

FIG. 10 is a side view illustrating a post-assembly state of a circuit board assembly according to an embodiment of the disclosure.

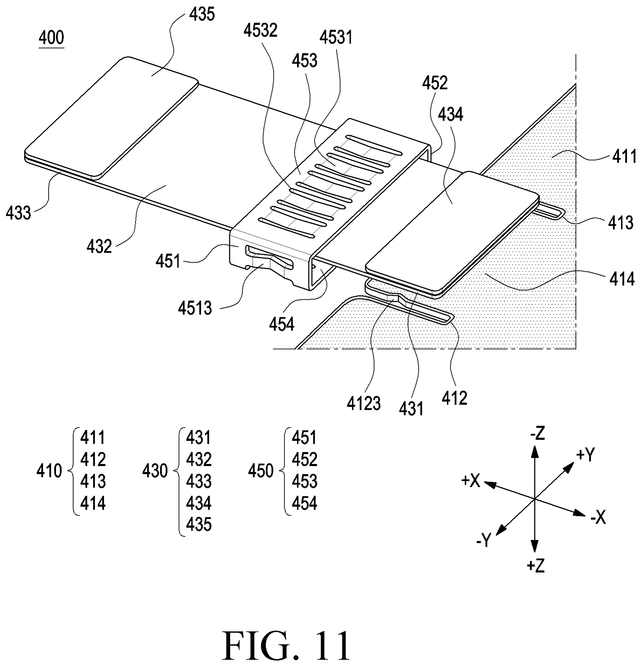

The embodiments of FIGS. 5 and 10 may be combined with the embodiments of FIGS. 1 to 4 or the embodiments of FIGS. 11 to 16.

Referring to FIGS. 5 to 10, the circuit board assembly 400 may include a first circuit board 410, a conductive connection member 430, or a bracket 450.

The configuration of the first circuit board 410 or the conductive connection member 430 of FIGS. 5 to 10 may be partially or entirely the same as the configuration of the first circuit board 310 or the conductive connection member 330 of FIG. 4.

The circuit board assembly 400 of FIGS. 5 to 10 is described as being applied to an electronic device such as a laptop as illustrated in FIGS. 2 to 4 (e.g., the electronic device 101 of FIGS. 1 to 4). However, the circuit board assembly 400 is not limited thereto and may be applied to various electronic devices such as a smartphone, a tablet PC, a refrigerator, an air conditioner, or a television. In addition, although the circuit board assembly 400 may be disposed inside the first housing 210 of FIGS. 2 to 3, the circuit board assembly 400 is not limited thereto and may be disposed inside the second housing 220 of FIGS. 2 to 3.

According to an embodiment, the first circuit board 410 may include a substrate portion 411, a first recess 412, a second recess 413, a first connector area 414, or a ground portion 415.

According to an embodiment, the substrate portion 411 of the first circuit board 410 may accommodate or mount a processor (e.g., the processor 120 of FIG. 1), memory (e.g., the memory 130 of FIG. 1), and/or an interface (e.g., the interface 177 of FIG. 1), or may be electrically connected to the above components. The processor may include at least one of, for example, a central processing unit, an application processor, a graphics processing unit, an image signal processor, a sensor hub processor, or a communication processor. According to various embodiments, the substrate portion 411 may include a flexible printed circuit board type radio frequency cable (FRC). For example, at least a portion of the substrate portion 411 may be electrically connected to an antenna module (e.g., the antenna module 197 of FIG. 1) and/or a communication module (e.g., the communication module 190 of FIG. 1).

According to an embodiment, the memory may include volatile memory (e.g., the volatile memory 132 of FIG. 1) or non-volatile memory (e.g., the non-volatile memory 134 of FIG. 1).

According to an embodiment, the interface may include a high-definition multimedia interface (HDMI), a universal serial bus (USB) interface, an SD card interface, and/or an audio interface. For example, the interface may electrically and/or physically connect the electronic device 101 to an external electronic device (e.g., the external electronic device 102 in FIG. 1), and may include a USB connector, an SD card/MMC connector, and/or or an audio connector.

According to an embodiment, the substrate portion 411 may be electrically connected to a battery (e.g., the battery 189 of FIG. 1). The battery may be a device configured to supply power to at least one component or electronic component of the electronic device (e.g., the electronic device 101 of FIGS. 1 to 4), and may include a non-rechargeable primary battery, a rechargeable secondary battery, or a fuel cell. According to an embodiment, the battery may be integrally disposed inside the housing (e.g., the housing 202 of FIGS. 2 to 3 or the housing 302 of FIG. 4). According to an embodiment, the battery may be detachably disposed in the housing.

According to an embodiment, the substrate portion 411 may include a front surface (e.g., a surface facing the -Z direction of FIGS. 5 to 9) and a rear surface facing opposite to the front surface (e.g., a surface facing the +Z direction of FIGS. 5 to 9). A first connector 4141 may be disposed on the front surface of the substrate portion 411, and the ground portion 415 may be disposed on the rear surface of the substrate portion 411.

According to an embodiment, the first circuit board 410 may include a first recess 412 or a second recess 413 recessed from an edge of the substrate portion 411 (e.g., an edge facing the +X direction of FIGS. 5 to 6).

According to an embodiment, at least a portion of a first side wall 451 of the bracket 450 may be disposed in the first recess 412. For example, the first side wall 451 of the bracket 450 may be inserted into or positioned in the first recess 412. The first recess 412 may have, in cross section, a shape of a groove recessed from the edge of the substrate portion 411 in a substantially rectangular cross-section having a long side and a short side. However, the first recess 412 is not limited thereto and may have various cross-sectional shapes capable of accommodating the first side wall 451.

According to an embodiment, the second recess 413 may accommodate at least a portion of a second side wall 452 of the bracket 450. For example, the second side wall 452 of the bracket 450 may be inserted into or positioned in the second recess 413. The second recess 413 may have, in cross section, a shape of a groove recessed from the edge of the substrate portion 411 in a substantially rectangular cross section having a long side and a short side. However, the second recess 413 is not limited thereto and may have various cross-sectional shapes capable of accommodating the second side wall 452.

According to an embodiment, the second recess 413 may be substantially parallel to the first recess 412. In addition, the second recess 413 may be spaced apart from the first recess 412.

According to an embodiment, the first circuit board 410 may include a first connector area 414 defined as at least a portion of the substrate portion 411. Both side edges of the first connector area 414 (e.g., an edge facing the +Y direction in FIG. 7 and an edge facing the -Y direction in FIG. 7) may be defined by at least a portion of the first recess 412 and at least a portion of the second recess 413. For example, the first connector area 414 may include three edges (e.g., an edge facing the +Y direction in FIG. 7, an edge facing the -Y direction in FIG. 7, and an edge facing the +X direction in FIG. 7). However, the number of edges of the first connector area 414 is not limited thereto and may be provided in various numbers.

According to an embodiment, the first connector area 414 may be an area that overlaps with or faces a second connector area 431 of the conductive connection member 430 when the first circuit board 410 and the conductive connection member 430 are physically and/or electrically connected.

According to an embodiment, the first circuit board 410 may include a first connector 4141 disposed on at least a portion of a front surface of the first connector area 414 (e.g., a surface facing the -Z direction in FIGS. 5 to 8). The first connector 4141 may be coupled to a second connector 431a of the conductive connection member 430. For example, the first circuit board 410 may be electrically connected to the conductive connection member 430 via the first connector 4141 and the second connector 431a. According to an embodiment, the first connector 4141 may include a board-to-board connector and/or a board-to-flexible printed circuit board connector.

For example, the first connector 4141 may include a structure that restricts horizontal movement of the second connector 431a of the conductive connection member 430. For example, the first connector 4141 may be vertically coupled to the second connector 431a of the conductive connection member 430.

According to an embodiment, the first circuit board 410 may include a ground portion 415 disposed on at least a portion of a rear surface of the first connector area 414 (e.g., a surface facing the +Z direction in FIGS. 5 to 8). The ground portion 415 may be connected to a second fixing portion 4541 of the bracket 450. The ground portion 415 may be a ground plane formed of a metal material and may provide the ground plane to the bracket 450.

According to an embodiment (see, e.g., FIG. 10), the first connector 4141 may overlap with the ground portion 415 with the first connector area 414 interposed therebetween. For example, the position of the first connector 4141 in the first connector area 414 may correspond to the position of the ground portion 415 in the first connector area 414.

According to an embodiment, the first circuit board 410 may further include a third recess 4121 recessed from at least a portion of the first recess 412.

According to an embodiment, the third recess 4121 may be recessed from at least a portion of the substrate portion 411 that defines the first recess 412. For example, the third recess 4121 may be recessed from at least a portion of the first recess 412 that faces an outer surface of the first side wall 451 of the bracket 450 (e.g., a surface facing the - Y direction in FIGS. 5 to 9).

According to an embodiment, at least a portion of a first inserting portion 4511 of the bracket 450 may be disposed in the third recess 4121. For example, the first inserting portion 4511 of the bracket 450 may be inserted into or positioned in the third recess 4121. The third recess 4121 may have a triangular shape in cross section so as to correspond to a shape of an outer surface of the first inserting portion 4511 (e.g., a surface facing the -Y direction in FIGS. 5 to 9), but is not limited thereto. The third recess 4121 may be formed in a portion of the first recess 412 facing the outer surface of the first side wall 451 of the bracket 450. According to an embodiment, a plurality of the third recesses 4121 may be formed.

According to an embodiment, the first circuit board 410 may further include a fourth recess 4131 recessed from at least a portion of the second recess 413.

According to an embodiment, the fourth recess 4131 may be recessed from at least a portion of the substrate portion 411 that defines the second recess 413. For example, the fourth recess 4131 may be recessed from at least a portion of the second recess 413 that faces an outer surface of the first side wall 451 of the bracket 450 (e.g., a surface facing the +Y direction in FIGS. 5 to 9).

According to an embodiment, at least a portion of a second inserting portion 4521 of the bracket 450 may be disposed in the fourth recess 4131. For example, the second inserting portion 4521 of the bracket 450 may be inserted into or positioned in the fourth recess 4131. The fourth recess 4131 may have a triangular shape in cross section so as to correspond to a shape of an outer surface of the second inserting portion 4521 (e.g., a surface facing the +Y direction in FIGS. 5 to 9), but is not limited thereto. The fourth recess 4131 may be formed in a portion of the second recess 413 facing the outer surface of the second side wall 452 of the bracket 450. According to an embodiment, a plurality of the fourth recesses 4131 may be formed.

According to an embodiment, the conductive connection member 430 may be electrically connected to the first circuit board 410. The conductive connection member 430 may electrically connect the first circuit board 410 to a second circuit board (e.g., the second circuit board 320 of FIG. 4) or may electrically connect the first circuit board 410 to a separate electrical component (e.g., a display, a battery, or a speaker).

According to an embodiment, the conductive connection member 430 may include at least one of a flexible printed circuit board (FPCB), a printed circuit board (PCB), and a cable.

According to an embodiment, the conductive connection member 430 may include a second connector area 431, an extension area 432, a third connector area 433, a first reinforcement member 434, and a second reinforcement member 435.

According to an embodiment, the second connector area 431, the extension area 432, and the third connector area 433 may be formed integrally, but are not limited thereto.

According to an embodiment, the second connector area 431 may be an area that overlaps with or faces the first connector area 414 of the first circuit board 410 when the first circuit board 410 and the conductive connection member 430 are physically and/or electrically connected.

According to an embodiment, the conductive connection member 430 may further include a second connector 431a disposed on one surface of the second connector area 431 that faces the first connector area 414. The second connector 431a of the conductive connection member 430 may be physically and/or electrically connected to the first connector 4141 of the first circuit board 410.

According to an embodiment, the third connector area 433 may be electrically connected to a second circuit board (e.g., the second circuit board 320 of FIG. 4). The third connector area 433 may be electrically connected to a battery, a display (e.g., the display 204 of FIG. 3), a speaker, or various electrical components of the electronic device (e.g., the electronic device 101 of FIGS. 1 to 4).

According to an embodiment (see, e.g., FIG. 10), the conductive connection member 430 may further include a third connector 433a disposed in the third connector area 433. The third connector 433a of the conductive connection member 430 may be physically and/or electrically connected to a connector of the second circuit board or various electrical components.

According to an embodiment, the extension area 432 may connect the second connector area 431 and the third connector area 433. The extension area 432 may be defined as an area extending from the second connector area 431 to the third connector area 433, or as an area extending from the third connector area 433 to the second connector area 431.

According to an embodiment, the conductive connection member 430 may further include a first reinforcement member 434 or a second reinforcement member 435. The first reinforcement member 434 and the second reinforcement member 435 may each be defined as and/or referred to as a first stiffener 434 and a second stiffener 435, respectively.

According to an embodiment, the first reinforcement member 434 may be disposed on one surface of the second connector area 431. For example, the position of the first reinforcement member 434 may overlap with or correspond to the position of the second connector 431a with the second connector area 431 interposed therebetween.

According to an embodiment, the first reinforcement member 434 may be configured to cover at least a portion of the second connector area 431. The first reinforcement member 434 may be attached or coupled to at least a portion of the second connector area 431.

According to an embodiment, the first reinforcement member 434 may limit or reduce direct transmission of external impact to the second connector area 431.

According to an embodiment, the second reinforcement member 435 may be disposed on one surface of the third connector area 433. For example, the position of the second reinforcement member 435 may overlap with or correspond to the position of the third connector 433a with the third connector area 433 interposed therebetween.

According to an embodiment, the second reinforcement member 435 may be configured to cover at least a portion of the third connector area 433. The second reinforcement member 435 may be attached or coupled to at least a portion of the third connector area 433.

According to an embodiment, the second reinforcement member 435 may limit or reduce direct transmission of external impact to the third connector area 433.

According to an embodiment, the bracket 450 may be disposed to surround at least a portion of the first circuit board 410 and at least a portion of the conductive connection member 430. For example, when the first circuit board 410 and the conductive connection member 430 are coupled, the bracket 450 may limit or reduce separation of the conductive connection member 430 from the first circuit board 410.

According to an embodiment, the bracket 450 may include a first side wall 451, a second side wall 452, a third side wall 453, a fourth side wall 454, a first inserting portion 4511, a second inserting portion 4521, a first fixing portion 4531, a second fixing portion 4541, and at least one opening 4512, 4522, 4532, or 4542.

According to an embodiment, the bracket 450 may include a metal material (e.g., stainless steel) and may be formed integrally, but is not limited thereto, and may alternatively be formed by assembling a plurality of members. The bracket 450 may also be formed of a non-metallic material.

According to an embodiment, the bracket 450 may have a loop shape or a ring shape defined by a combination of the first side wall 451, the second side wall 452, the third side wall 453, and the fourth side wall 454, but is not limited thereto.

According to an embodiment, the first side wall 451 may be spaced apart from and substantially parallel to the second side wall 452. At least a portion of the first side wall 451 may be inserted into the first recess 412 of the first circuit board 410.

According to an embodiment, the bracket 450 may include a first inserting portion 4511 disposed on or formed on the first side wall 451. According to an embodiment, the first inserting portion 4511 may be a portion formed on at least a portion of the first side wall 451. The first inserting portion 4511 may be formed by bending at least a portion of the first side wall 451. The first inserting portion 4511 may be formed to protrude from the first side wall 451. For example, the first inserting portion 4511 may be defined and/or interpreted as a portion protruding from at least a portion of the first side wall 451.

According to an embodiment, the first inserting portion 4511 may be disposed to face outward from the bracket 450. For example, the first inserting portion 4511 may protrude or extend outward from the first side wall 451 of the bracket 450 to the outside of the bracket 450 (e.g., in the -Y direction in FIG. 9). For example, the first inserting portion 4511 may protrude from the first side wall 451 in a direction away from the second side wall 452 (e.g., the -Y direction in FIG. 9).

According to an embodiment, the first inserting portion 4511 may be inserted into the third recess 4121 of the first circuit board 410. The first inserting portion 4511 and the third recess 4121 may provide a locking structure, thereby restricting or reducing separation of the conductive connection member 430 from the first circuit board 410.

According to an embodiment, the second side wall 452 may be spaced apart from the first side wall 451 and may be substantially parallel to the first side wall 451. At least a portion of the second side wall 452 may be inserted into the second recess 413 of the first circuit board 410.

According to an embodiment, the bracket 450 may include a second inserting portion 4521 disposed or formed on the second side wall 452. The second inserting portion 4521 may be a portion formed on at least a portion of the second side wall 452. The second inserting portion 4521 may be formed by bending at least a portion of the second side wall 452. The second inserting portion 4521 may be formed to protrude from the second side wall 452. For example, the second inserting portion 4521 may be defined and/or interpreted as a portion protruding from at least a portion of the second side wall 452.

According to an embodiment, the second inserting portion 4521 may be disposed to face the outside of the bracket 450. For example, the second inserting portion 4521 may protrude or extend from the second side wall 452 toward the outside of the bracket 450 (e.g., in the +Y direction in FIG. 9). For example, the second inserting portion 4521 may protrude from the second side wall 452 in a direction away from the first side wall 451 (e.g., the +Y direction in FIG. 9).

According to an embodiment, the second inserting portion 4521 may be inserted into the fourth recess 4131 of the first circuit board 410. The second inserting portion 4521 and the fourth recess 4131 may provide a locking structure, thereby restricting or reducing separation of the conductive connection member 430 from the first circuit board 410.

According to an embodiment, the third side wall 453 may be spaced apart from the fourth side wall 454 and may be substantially parallel to the fourth side wall 454. At least a portion of the third side wall 453 may cover at least a portion of the first reinforcement member 434.

According to an embodiment, the third side wall 453 may be connected to one end of the first side wall 451 (e.g., an end facing the -Z direction in FIG. 9) and one end of the second side wall 452 (e.g., an end facing the -Z direction in FIG. 9).

According to an embodiment, the bracket 450 may include a first fixing portion 4531 disposed or formed on the third side wall 453. The first fixing portion 4531 may be a portion formed on at least a portion of the third side wall 453. The first fixing portion 4531 may be formed by bending at least a portion of the third side wall 453. The first fixing portion 4531 may be formed to protrude from the third side wall 453.

According to an embodiment, the first fixing portion 4531 may be disposed to face the inside of the bracket 450. For example, the first fixing portion 4531 may protrude or extend from the third side wall 453 of the bracket 450 toward the inside of the bracket 450 (e.g., in the +Z direction in FIG. 9).

According to an embodiment, the first fixing portion 4531 may be configured to press the first reinforcement member 434 or the second connector area 431.

According to an embodiment, the fourth side wall 454 may be spaced apart from the third side wall 453 and may be substantially parallel to the third side wall 453. At least a portion of the fourth side wall 454 may cover at least a portion of the first reinforcement member 434.

According to an embodiment, the fourth side wall 454 may be connected to the other end of the first side wall 451 (e.g., an end facing the +Z direction in FIG. 9) and the other end of the second side wall 452 (e.g., an end facing the +Z direction in FIG. 9).

According to an embodiment, the bracket 450 may include a second fixing portion 4541 disposed or formed on the fourth side wall 454. The second fixing portion 4541 may be a portion formed on at least a portion of the fourth side wall 454. The second fixing portion 4541 may be formed by bending at least a portion of the fourth side wall 454. The second fixing portion 4541 may be formed to protrude from the fourth side wall 454.

According to an embodiment, the second fixing portion 4541 may be disposed to face the inside of the bracket 450. For example, the second fixing portion 4541 may protrude or extend from the fourth side wall 454 toward the inside of the bracket 450 (e.g., in the -Z direction in FIG. 9).

According to an embodiment, the second fixing portion 4541 may be configured to press the first connector area 414 of the first circuit board 410.

According to an embodiment, the first fixing portion 4531 and the second fixing portion 4541 may restrict or reduce separation of the conductive connection member 430 from the first circuit board 410 by pressing the first connector area 414 and the second connector area 431 from upper and lower sides. For example, the first fixing portion 4531 may be in contact with the first reinforcement member 434 and may press the second connector area 431 through the first reinforcement member 434. The second fixing portion 4541 may be in contact with the first connector area 414 and may press the first connector area 414.

According to an embodiment, the first inserting portion 4511 may be in contact with at least a portion of the third recess 4121. A portion of the third recess 4121 that is in contact with the first inserting portion 4511 may be provided as a ground plane.

According to an embodiment, the second inserting portion 4521 may be in contact with at least a portion of the fourth recess 4131. A portion of the fourth recess 4131 that is in contact with the second inserting portion 4521 may be provided as a ground plane.

According to an embodiment, the second fixing portion 4541 may be in contact with the ground portion 415 of the first circuit board 410. The ground portion 415 may be provided as a ground plane.

According to an embodiment, at least a portion of the bracket 450 may be electrically connected to the ground plane of the first circuit board 410. The bracket 450 may provide an electromagnetic interference (EMI) shielding function and/or a radio frequency interference (RFI) shielding function by being electrically connected to the ground plane of the first circuit board 410.

According to an embodiment, the bracket 450 may further include at least one opening 4512, 4522, 4532, or 4542. The at least one opening 4512, 4522, 4532, or 4542 may be formed through the side walls 451, 452, 453, and 454 of the bracket 450. The at least one opening 4512, 4522, 4532, or 4542 may be provided as a passage connecting the inside and outside of the bracket 450. The at least one opening 4512, 4522, 4532, or 4542 may be configured to allow circulation of air so as to assist in dissipating heat accumulated in a portion where the first circuit board 410 and the conductive connection member 430 are connected.

According to an embodiment, the at least one opening 4512, 4522, 4532, or 4542 may include a first opening 4512 formed in the first side wall 451, a second opening 4522 formed in the second side wall 452, a third opening 4532 formed in the third side wall 453, or a fourth opening 4542 formed in the fourth side wall 454.

Hereinafter, an assembly process of the first circuit board 410 and the conductive connection member 430 will be described with reference to FIGS. 5 and 6.

Referring to FIG. 5, the second connector area 431 of the conductive connection member 430 may be aligned with the first connector area 414 of the first circuit board 410. The second connector 431a of the conductive connection member 430 and the first connector 4141 of the first circuit board 410 may be physically and/or electrically coupled.

In the state in which the second connector 431a and the first connector 4141 are coupled and the extension area 432 is located inside the bracket 450, the bracket 450 may be slid toward the first circuit board 410 along the extension area 432.

Referring to FIG. 6, the bracket 450 may be disposed to surround at least a portion of the first connector area 414 and at least a portion of the second connector area 431. In the state in which the bracket 450 is coupled to the conductive connection member 430 and the first circuit board 410 (e.g., FIG. 6), the first side wall 451 and the second side wall 452 of the bracket 450 may each be inserted into the first recess 412 and the second recess 413. The first inserting portion 4511 and the second inserting portion 4521 may each be press-fitted into the third recess 4121 and the fourth recess 4131. The first fixing portion 4531 and the second fixing portion 4541 may restrain upper and lower sides of a portion in which the first connector area 414 and the second connector area 431 are coupled.

According to an embodiment, because the first connector area 414 and the second connector area 431 are disposed inside the bracket 450, separation of the second connector area 431 of the conductive connection member 430 from the first connector area 414 of the first circuit board 410 may be restricted or prevented.

According to an embodiment, because the first inserting portion 4511 and the second inserting portion 4521 are press-fitted into the third recess 4121 and the fourth recess 4131, respectively, separation of the bracket 450 from a portion in which the first connector area 414 and the second connector area 431 are coupled may be restricted or prevented.

A disassembly process of the first circuit board 410 and the conductive connection member 430 may be performed in a reverse order of the assembly process. During the disassembly process, the bracket 450 may be separable from the portion in which the first connector area 414 and the second connector area 431 are coupled. Thereafter, when reassembling the first circuit board 410 and the conductive connection member 430, the bracket 450 may be reusable.

FIG. 11 is a perspective view illustrating a pre-assembly state of a bracket of a circuit board assembly according to an embodiment of the disclosure.

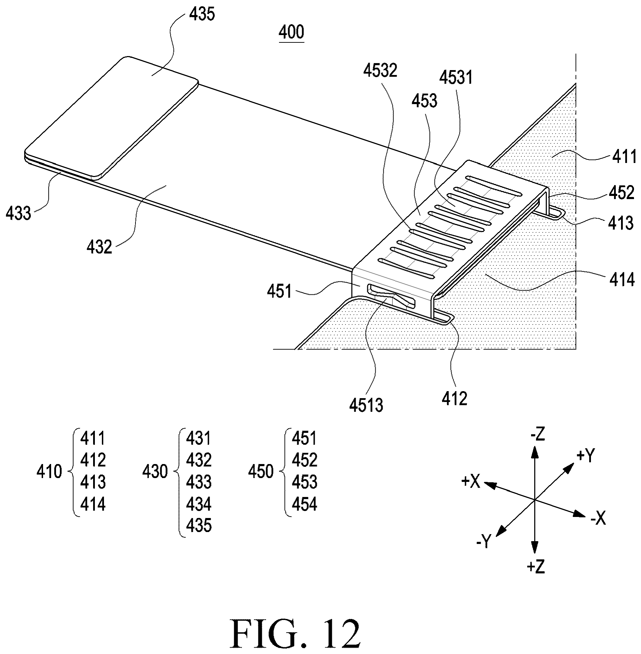

FIG. 12 is a perspective view illustrating a post-assembly state of the bracket of the circuit board assembly according to an embodiment of the disclosure.

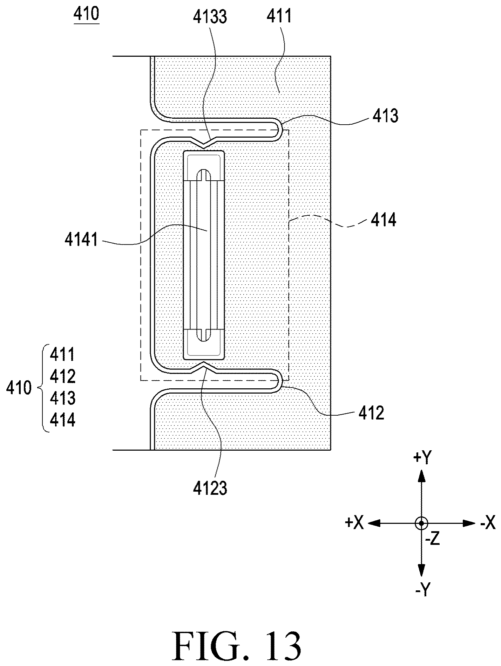

FIG. 13 is a plan view illustrating a connector of a first circuit board according to an embodiment of the disclosure.

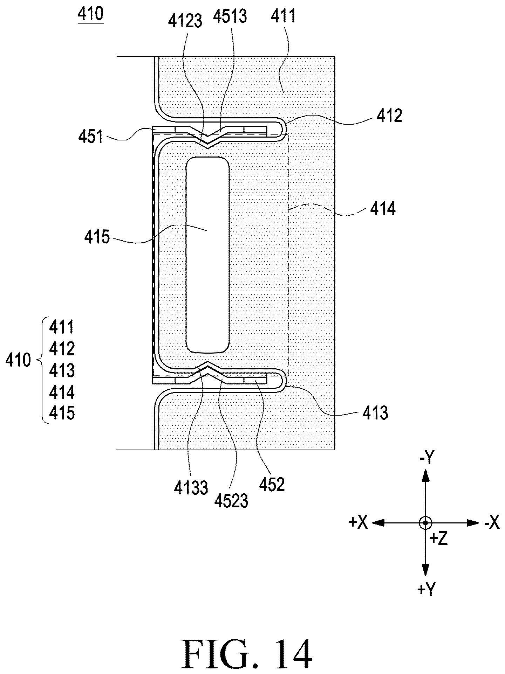

FIG. 14 is a plan view illustrating a ground of the first circuit board according to an embodiment of the disclosure.

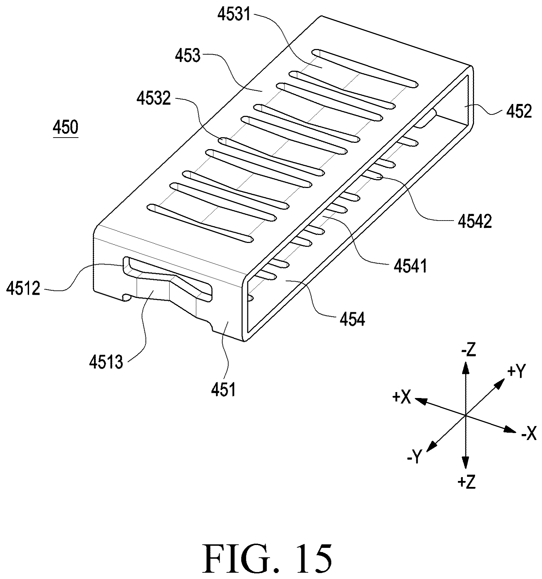

FIG. 15 is a perspective view illustrating a bracket according to an embodiment of the disclosure.

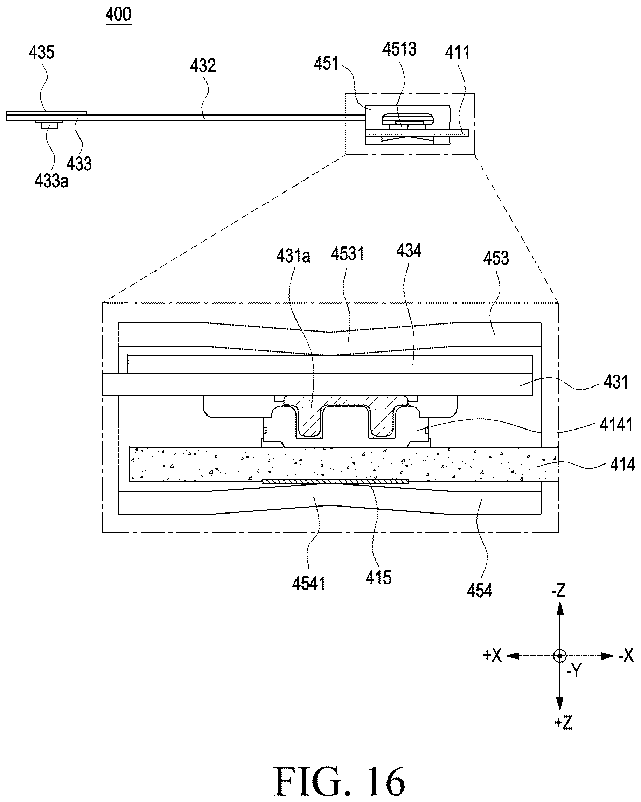

FIG. 16 is a side view illustrating a post-assembly state of a circuit board assembly according to an embodiment of the disclosure.

The embodiments of FIGS. 11 to 16 may be combined with the embodiments of FIGS. 1 to 10.

Referring to FIGS. 11 to 16, a circuit board assembly 400 (e.g., the circuit board assembly 400 of FIGS. 5 to 10) may include a first circuit board 410, a conductive connection member 430, or a bracket 450. The first circuit board 410 may include a substrate portion 411, a first recess 412, a second recess 413, a first connector area 414, a first connector 4141, or a ground portion 415. The conductive connection member 430 may include a second connector area 431, a second connector 431a, an extension area 432, a third connector area 433, a third connector 433a, a first reinforcement member 434, or a second reinforcement member 435. The bracket 450 may include a first side wall 451, a second side wall 452, a third side wall 453, a fourth side wall 454, a first fixing portion 4531, a second fixing portion 4541, or at least one opening 4512, 4522, 4532, or 4542.

According to an embodiment, the conductive connection member 430 may include at least one of a flexible printed circuit board (FPCB), a printed circuit board (PCB), and a cable.

According to an embodiment, the configurations of the circuit board assembly 400, the first circuit board 410, the substrate portion 411, the first recess 412, the second recess 413, the first connector area 414, the first connector 4141, the ground portion 415, the conductive connection member 430, the second connector area 431, the second connector 431a, the extension area 432, the third connector area 433, the third connector 433a, the first reinforcement member 434, the second reinforcement member 435, the bracket 450, the first side wall 451, the second side wall 452, the third side wall 453, the fourth side wall 454, the first fixing portion 4531, the second fixing portion 4541, or the at least one opening 4512, 4522, 4532, or 4542 of FIGS. 11 to 16 may be partially or entirely the same as the configurations of the circuit board assembly 400, the first circuit board 410, the substrate portion 411, the first recess 412, the second recess 413, the first connector area 414, the first connector 4141, the ground portion 415, the conductive connection member 430, the second connector area 431, the second connector 431a, the extension area 432, the third connector area 433, the third connector 433a, the first reinforcement member 434, the second reinforcement member 435, the bracket 450, the first side wall 451, the second side wall 452, the third side wall 453, the fourth side wall 454, the first fixing portion 4531, the second fixing portion 4541, or the at least one opening 4512, 4522, 4532, or 4542 of FIGS. 5 to 10.

According to an embodiment, the first circuit board 410 may further include a third recess 4123 recessed from at least a portion of the first recess 412.

According to an embodiment, the third recess 4123 may be recessed from at least a portion of the substrate portion 411 that defines the first recess 412. For example, the third recess 4123 may be recessed from at least a portion of the first recess 412 that faces an inner surface of the first side wall 451 of the bracket 450 (e.g., a surface facing the +Y direction in FIGS. 11 to 15).

According to an embodiment, at least a portion of a first inserting portion 4513 of the bracket 450 may be disposed in the third recess 4123. For example, the first inserting portion 4513 of the bracket 450 may be inserted into or positioned in the third recess 4123. The third recess 4123 may have a triangular shape in cross section so as to correspond to a shape of an outer surface of the first inserting portion 4513 (e.g., a surface facing the +Y direction in FIGS. 11 to 15), but is not limited thereto. The third recess 4123 may be formed in a portion of the first recess 412 facing the inner surface of the first side wall 451 of the bracket 450.

According to an embodiment, the first circuit board 410 may further include a fourth recess 4133 recessed from at least a portion of the second recess 413.

According to an embodiment, the fourth recess 4133 may be recessed from at least a portion of the substrate portion 411 that defines the second recess 413. For example, the fourth recess 4133 may be recessed from at least a portion of the second recess 413 that faces an inner surface of the first side wall 451 of the bracket 450 (e.g., a surface facing the -Y direction in FIGS. 11 to 15).

According to an embodiment, at least a portion of a second inserting portion 4523 of the bracket 450 may be disposed in the fourth recess 4133. For example, the second inserting portion 4523 of the bracket 450 may be inserted into or positioned in the fourth recess 4133. The fourth recess 4133 may have a triangular shape in cross section so as to correspond to a shape of an inner surface of the second inserting portion 4523 (e.g., a surface facing the +Y direction in FIGS. 11 to 15), but is not limited thereto. The fourth recess 4133 may be formed in a portion of the second recess 413 facing the inner surface of the second side wall 452 of the bracket 450.

According to an embodiment, the bracket 450 may include a first inserting portion 4513 disposed on or formed on the first side wall 451. According to an embodiment, the first inserting portion 4513 may be a portion formed on at least a portion of the first side wall 451. The first inserting portion 4513 may be formed by bending at least a portion of the first side wall 451. The first inserting portion 4513 may be formed to protrude from the first side wall 451. For example, the first inserting portion 4513 may be defined and/or interpreted as a portion protruding from at least a portion of the first side wall 451.

According to an embodiment, the first inserting portion 4513 may be disposed to face the inside of the bracket 450. For example, the first inserting portion 4513 may protrude or extend outward from the first side wall 451 of the bracket 450 to the inside of the bracket 450 (e.g., in the +Y direction in FIG. 15). For example, the first inserting portion 4513 may protrude from the first side wall 451 in a direction toward the second side wall 452 (e.g., the +Y direction in FIG. 15).

According to an embodiment, the first inserting portion 4513 may be inserted into the third recess 4123 of the first circuit board 410. The first inserting portion 4513 and the third recess 4123 may provide a locking structure, thereby restricting or reducing separation of the conductive connection member 430 from the first circuit board 410.

According to an embodiment, the bracket 450 may include a second inserting portion 4523 disposed or formed on the second side wall 452. The second inserting portion 4523 may be a portion formed on at least a portion of the second side wall 452. The second inserting portion 4523 may be formed by bending at least a portion of the second side wall 452. The second inserting portion 4523 may be formed to protrude from the second side wall 452. For example, the second inserting portion 4523 may be defined and/or interpreted as a portion protruding from at least a portion of the first side wall 452.

According to an embodiment, the second inserting portion 4523 may be disposed to face the inside of the bracket 450. For example, the second inserting portion 4523 may protrude or extend outward from the second side wall 452 of the bracket 450 to the inside of the bracket 450 (e.g., in the +Y direction in FIG. 15). For example, the first inserting portion 4513 may protrude from the second side wall 452 in a direction toward the first side wall 451 (e.g., the +Y direction in FIG. 15).

According to an embodiment, the second inserting portion 4523 may be inserted into the fourth recess 4133 of the first circuit board 410. The second inserting portion 4523 and the fourth recess 4133 may provide a locking structure, thereby restricting or reducing separation of the conductive connection member 430 from the first circuit board 410.

According to an embodiment, the first inserting portion 4513 may be in contact with at least a portion of the third recess 4123. A portion of the third recess 4123 that is in contact with the first inserting portion 4513 may be provided as a ground plane.

According to an embodiment, the second inserting portion 4523 may be in contact with at least a portion of the fourth recess 4133. A portion of the fourth recess 4133 that is in contact with the second inserting portion 4523 may be provided as a ground plane.

According to an embodiment, the second fixing portion 4541 may be in contact with the ground portion 415 of the first circuit board 410. The ground portion 415 may be provided as a ground plane.

According to an embodiment, at least a portion of the bracket 450 may be electrically connected to the ground plane of the first circuit board 410. The bracket 450 may provide an electromagnetic interference (EMI) shielding function and/or a radio frequency interference (RFI) shielding function by being electrically connected to the ground plane of the first circuit board 410.

Hereinafter, an assembly process of the first circuit board 410 and the conductive connection member 430 will be described with reference to FIGS. 11 and 12.

Referring to FIG. 11, the second connector area 431 of the conductive connection member 430 may be aligned with the first connector area 414 of the first circuit board 410. The second connector 431a of the conductive connection member 430 and the first connector 4141 of the first circuit board 410 may be physically and/or electrically coupled.

In the state in which the second connector 431a and the first connector 4141 are coupled and the extension area 432 is located inside the bracket 450, the bracket 450 may be slid toward the first circuit board 410 along the extension area 432.

Referring to FIG. 12, the bracket 450 may be disposed to surround at least a portion of the first connector area 414 and at least a portion of the second connector area 431. In the state in which the bracket 450 is coupled to the conductive connection member 430 and the first circuit board 410 (e.g., FIG. 12), the first side wall 451 and the second side wall 452 of the bracket 450 may each be inserted into the first recess 412 and the second recess 413. The first inserting portion 4513 and the second inserting portion 4523 may each be press-fitted into the third recess 4123 and the fourth recess 4133. The first fixing portion 4531 and the second fixing portion 4541 may restrain upper and lower sides of a portion in which the first connector area 414 and the second connector area 431 are coupled.

According to an embodiment, because the first connector area 414 and the second connector area 431 are disposed inside the bracket 450, separation of the second connector area 431 of the conductive connection member 430 from the first connector area 414 of the first circuit board 410 may be restricted or prevented.

According to an embodiment, because the first inserting portion 4513 and the second inserting portion 4523 are press-fitted into the third recess 4123 and the fourth recess 4133, respectively, separation of the bracket 450 from a portion in which the first connector area 414 and the second connector area 431 are coupled may be restricted or prevented.

A disassembly process of the first circuit board 410 and the conductive connection member 430 may be performed in a reverse order of the assembly process. During the disassembly process, the bracket 450 may be separable from the portion in which the first connector area 414 and the second connector area 431 are coupled. Thereafter, when reassembling the first circuit board 410 and the conductive connection member 430, the bracket 450 may be reusable.

According to an embodiment, when the third recess 4123 is formed in a portion of the first recess 412 that faces an inner surface of the first side wall 451, and the fourth recess 4133 is formed in a portion of the second recess 413 that faces an inner surface of the second side wall 452, at least a portion of the substrate portion 411 of the first circuit board 410 (e.g., a portion that faces an outer surface of the first side wall 451 or a portion that faces an outer surface of the second side wall 452) may be omitted or removed.

As electronic devices become smaller or thinner, it may be difficult to sufficiently secure space inside an electronic device for components to be disposed. An electronic device may be provided with a printed circuit board on which at least one electrical component is disposed or mounted, and a conductive connection member electrically connected to the printed circuit board.

The printed circuit board and the conductive connection member may be electrically connected via a connector structure. The conductive connection member may be at risk of being separated from the printed circuit board due to an external impact applied to the electronic device. To prevent separation of the conductive connection member, an adhesive member such as a double-sided tape may be used. However, the adhesive member such as the double-sided tape has inconvenience in that removal of the adhesive member and installation of a new adhesive member are required when the electronic device is repaired. In addition, a method of fixing the conductive connection member to the printed circuit board through a separate fastening member (e.g., a bolt or a pin) may be used. However, the volume (or size) occupied by the fastening member may occupy a significant amount of space inside the electronic device.

According to an embodiment of the disclosure, a circuit board assembly that restricts separation of the conductive connection member and an electronic device including the same may be provided.

However, the problem intended to be solved by the disclosure is not limited to the above-described problems, and may be defined in various ways without departing from the spirit and scope of the disclosure.

According to an embodiment of the disclosure, a circuit board assembly that is easy to assemble and disassemble and an electronic device including the same may be provided.

The effects that are capable of being obtained by the disclosure are not limited to those described above, and other effects not described above may be clearly understood by a person ordinarily skilled in the art to which the disclosure belongs based on the following description.

According to an embodiment of the disclosure, an electronic device 101 may include a housing 302, a first circuit board 410, a conductive connection member 430, and a bracket 450. The first circuit board may be disposed in the housing. The first circuit board may include a first recess 412, a second recess 413, a first connector area 414, and a third recess 4121 or 4123. The first recess may be recessed from an edge of the first circuit board. The second recess may be recessed from an edge of the first circuit board. The second recess may be spaced apart from the first recess. Opposite edges of the first connector area may be defined by the first recess and the second recess. The third recess may be recessed from at least a portion of the first recess. The conductive connection member may include a second connector area 431. The second connector area may be electrically connected to the first connector area. The bracket may surround at least a portion of the first connector area and/or at least a portion of the second connector area. The bracket may include a first side wall 451, a second side wall 452, and a first inserting portion 4511 or 4513. The first side wall may be inserted into the first recess. The second side wall may be inserted into the second recess. The first inserting portion may be formed on the first side wall. The first inserting portion may be inserted into the third recess.

According to an embodiment, the first inserting portion 4511 may protrude from the first side wall. The first inserting portion may face a direction away from the second side wall.

According to an embodiment, the third recess 4121 may be formed in a portion of the first recess that faces an outer surface of the first side wall.

According to an embodiment, the first inserting portion 4513 may protrude from the first side wall. The first inserting portion may face a direction toward the second side wall.

According to an embodiment, the third recess 4123 may be formed in a portion of the first recess that faces an inner surface of the first side wall.

According to an embodiment, the first circuit board may further include a fourth recess 4131 or 4133. The fourth recess may be recessed from at least a portion of the second recess. The bracket may further include a second inserting portion 4521 or 4523. The second inserting portion may be formed on the second side wall. The second inserting portion may be inserted into the fourth recess.

According to an embodiment, the second inserting portion 4521 may protrude from the second side wall. The second inserting portion may face a direction away from the first side wall.

According to an embodiment, the fourth recess 4131 may be formed in a portion of the second recess that faces an outer surface of the second side wall.

According to an embodiment, the second inserting portion 4523 may protrude from the second side wall. The second inserting portion may face a direction toward the first side wall.

According to an embodiment, the fourth recess 4133 may be formed in a portion of the second recess that faces an inner surface of the second side wall.

According to an embodiment, the bracket may further include a third side wall 453 and a fourth side wall 454. The third side wall may connect one end of the first side wall and one end of the second side wall. The fourth side wall may connect the other end of the first side wall and the other end of the second side wall.

According to an embodiment, the bracket may further include a first fixing portion 4531 and a second fixing portion 4541. The first fixing portion may be formed on the third side wall. The first fixing portion may be configured to press at least a portion of the second connector area. The second fixing portion may be formed on the fourth side wall. The second fixing portion may be configured to press at least a portion of the first connector area.

According to an embodiment, the second fixing portion may be electrically connected to a ground portion 415 of the first circuit board.

According to an embodiment, the bracket may further include at least one opening 4512 or 4522. The at least one opening may be formed in the first side wall or the second side wall.

According to an embodiment, the conductive connection member may include at least one of a printed circuit board, a flexible printed circuit board, or a cable.

According to an embodiment of the disclosure, a circuit board assembly 400 may include a first circuit board 410, a conductive connection member 430, and a bracket 450. The first circuit board may include a first recess 412, a second recess 413, a first connector area 414, and a third recess 4121 or 4123. The first recess may be recessed from an edge of the first circuit board. The second recess may be recessed from an edge of the first circuit board. The second recess may be spaced apart from the first recess. Opposite edges of the first connector area may be defined by the first recess and the second recess. The third recess may be recessed from at least a portion of the first recess. The conductive connection member may include a second connector area 431. The second connector area may be electrically connected to the first connector area. The bracket may surround at least a portion of the first connector area and/or at least a portion of the second connector area. The bracket may include a first side wall 451, a second side wall 452, and a first inserting portion 4511 or 4513. The first side wall may be inserted into the first recess. The second side wall may be inserted into the second recess. The first inserting portion may be formed on the first side wall. The first inserting portion may be inserted into the third recess.

According to an embodiment, the first inserting portion 4511 may protrude from the first side wall. The first inserting portion may face a direction away from the second side wall.

According to an embodiment, the third recess 4121 may be formed in a portion of the first recess that faces an outer surface of the first side wall.

According to an embodiment, the first inserting portion 4513 may protrude from the first side wall. The first inserting portion may face a direction toward the second side wall.

According to an embodiment, the third recess 4123 may be formed in a portion of the first recess that faces an inner surface of the first side wall.

In the foregoing detailed description of this document, specific embodiments have been described. However, it will be evident to a person ordinarily skilled in the art that various modifications can be made without departing from the scope of the disclosure.

## Claims

1. An electronic device (101) comprising:
a housing (302);
a first circuit board (410) disposed in the housing, wherein the first circuit board includes:
a first recess (412) recessed from an edge of the first circuit board,
a second recess(413) recessed from the edge of the first circuit board and spaced apart from the first recess,
a first connector area (414), wherein both edges of the first connector area are defined by the first recess and the second recess, and
a third recess (4121, 4123) recessed in at least a portion of the first recess;
a conductive connection member (430) including a second connector area (431) electrically connected to the first connector area; and
a bracket (450) surrounding at least a portion of the first connector area and at least portion of the second connector area, wherein the bracket includes a first side wall (451) inserted into the first recess, a second side wall (452) inserted into the second recess, and a first inserting portion (4511, 4513) formed in the first side wall,
wherein the first inserting portion is inserted into the third recess.

2. The electronic device of claim 1, wherein the first inserting portion (4511) protrudes from the first side wall and faces a direction away from the second side wall.

3. The electronic device according to any one of claims 1 and 2, wherein the third recess (4121) is formed in a portion of the first recess that faces an outer surface of the first side wall.

4. The electronic device of any one of claims 1 to 3, wherein the first inserting portion (4513) protrudes from the first side wall and faces a direction toward the second side wall.

5. The electronic device of one of claims 1 to 4, wherein the third recess (4123) is formed in a portion of the first recess that faces an inner surface of the first side wall.

6. The electronic device of one of claims 1 to 5, wherein the first circuit board further includes a fourth recess (4131, 4133) recessed from at least a portion of the second recess,
wherein the bracket further includes a second inserting portion (4512, 4523) formed on the second side wall, and
wherein the second inserting portion is inserted in the fourth recess.

7. The electronic device of any one of claims 1 to 6, wherein the second inserting portion (4521) protrudes from the second side wall and faces a direction away from the first side wall.

8. The electronic device of one of claims 1 to 7, wherein the fourth recess (4131) is formed in a portion of the second recess that faces an outer surface of the second side wall.

9. The electronic device of one of claims 1 to 8, wherein the second inserting portion (4523) protrudes from the second side wall and faces a direction toward the first side wall.

10. The electronic device of one of claims 1 to 9, wherein the fourth recess (4133) is formed in a portion of the second recess that faces an inner surface of the second side wall.

11. The electronic device of one of claims 1 to 10, wherein the bracket further includes:
a third side wall (453) connecting one end of the first side wall and one end of the second side wall, and
a fourth side wall (454) connecting another end of the first side wall and another end of the second side wall.

12. The electronic device of one of claims 1 to 11, wherein the bracket further includes:
a first fixing portion (4531) formed on the third side wall and configured to press at least a portion of the second connector area, and
a second fixing portion (4541) formed on the fourth side wall and configured to press at least a portion of the first connector area.

13. The electronic device of one of claims 1 to 12, wherein the second fixing portion is electrically connected to a ground portion (415) of the first circuit board.

14. The electronic device of one of claims 1 to 14, wherein the bracket further includes at least one opening (4512, 4522) formed in the first side wall or the second side wall.

15. The electronic device of any one of claims 1 to 14, wherein the conductive connection member includes at least one of a printed circuit board, a flexible printed circuit board, or a cable.
